**Europäisches Patentamt**

**European Patent Office**

**Office européen des brevets**

(19)

(11) Veröffentlichungsnummer: **0 123 864**
A2

## (12) EUROPÄISCHE PATENTANMELDUNG

(21) Anmeldenummer: **84103008.3**

(22) Anmeldetag: **19.03.84**

(51) Int. Cl.³: **H 01 L 41/18**

(30) Priorität: **23.03.83 DE 3310589**

(43) Veröffentlichungstag der Anmeldung: **07.11.84**
**Patentblatt 84/45**

(84) Benannte Vertragsstaaten: **FR NL**

(71) Anmelder: **Siemens Aktiengesellschaft, Berlin und München Wittelsbacherplatz 2, D-8000 München 2 (DE)**

(72) Erfinder: **Meixner, Hans, Dr., Max-Planck-Strasse 5, D-8013 Haar (DE)**
Erfinder: **Mágori, Valentin, Dipl.-Phys., Limburgstrasse 17, D-8000 München 90 (DE)**

(54) Kunstharz-imprägnierter Piezokeramikkörper.

(57) Mit Kunstharz im B-Zustand imprägnierter Piezokeramikkörper (4), der mit Elektroden (3, 5) zu versehen oder bereits versehen ist, wobei die Klebverbindung zwischen dem Piezokeramikkörper (4) und den Elektroden (3, 5) durch das erst nachfolgend ausgehärtete Kunstharz bewirkt ist.

EP 0 123 864 A2

0123864

SIEMENS AKTIENGESELLSCHAFT    Unser Zeichen
Berlin und München           VPA 83 P 1 1 9 2 E

## Kunstharz-imprägnierter Piezokeramikkörper.

Die vorliegende Erfindung bezieht sich auf Piezokeramikkörper, wie sie im Oberbegriff des Patentanspruchs 1 angegeben sind.

Seit Jahrzehnten ist die Verwendung von lamellenförmigen Keramikstreifen und von Keramikfolien bekannt; z.B. für Bimorph-Biegestreifen bzw. für Membranfolien. Beiden Ausführungsformen piezoelektrischer Keramik aus beispielsweise Bariumtitanat oder Blei-Zirkontitanat ist gemeinsam, daß die Materialstärke der Streifen oder Folien sehr gering ist und sogar kleiner als 0,1 mm sein kann. Für ein Keramikmaterial sind derartige Dickenabmessungen außergewöhnlich. Dennoch hat man derartige Streifen und Folien für technische Produkte weiterverarbeitet und/oder direkt verwendet.

Für die Verwendung von dünnen piezokeramischen Streifen oder Folien mußte stets wesentliche Rücksicht auf deren Brüchigkeit genommen werden, ohne daß man trotz vielseitiger Bestrebungen dieses Problem zufriedenstellend lösen konnte.

Es ist eine Aufgabe der vorliegenden Erfindung, dünne piezokeramische Streifen oder Folien, d.h. das dazu verwendete Keramikmaterial, derart zu behandeln, daß deren bzw. dessen Brüchigkeit entscheidend verringert oder beseitigt ist, die Weiterverarbeitbarkeit der Streifen und Folien jedoch dadurch nicht eingeschränkt wird.

Bts 1 Bla / 23.3.1983

0123864

83 P 1192 E

Diese Aufgabe wird mit Piezokeramik nach dem Oberbegriff des Patentanspruchs 1 gelöst, die die Merkmale nach dem Kennzeichen des Anspruchs 1 bzw. 2 hat. Ausgestaltungen und Weiterbildungen der Erfindung gehen aus Unteransprüchen hervor.

Die Erfindung sieht eine als Imprägnierung zu bezeichnende Behandlung der Piezokeramik-Streifen oder -Folien vor, und zwar mit einem solchen an sich bekannten Kunstharz, das nach Durchführung der Imprägnierung in den sogenannten B-Zustand gebracht werden kann. Derartige bekannte Kunstharze findet man vorzugsweise unter den ungesättigten Polyesterharzen. Hierzu sei auch auf die DE-OS 24 16 344 hingewiesen, die chemische Verbindungen angibt, die sehr gut zur Überführung in den B-Zustand geeignet sind (Wittfoht, Kunststofftechnisches Wörterbuch, Verlag Hanser, München-Wien, (1978) S.226).
Der erwähnte B-Zustand zeichnet sich dadurch aus, daß in diesem Zustand das (in das Keramikmaterial bereits hineinimprägnierte) Material noch nicht ausgehärtet ist, aber dennoch bereits als eine Art erstarrte Schmelze dem Keramikmaterial wesentlich höhere mechanische Stabilität verleiht. Im B-Zustand ist das Kunstharz-Material außerdem auch nicht klebrig. Dies ist insbesondere für gute Handhabbarkeit der in Frage kommenden imprägnierten Piezokeramik-Teile von großem Vorteil, z.B. für die Justierung derselben an dem Ort, an dem sie anzubringen sind.

Bei nachfolgender Erwärmung wird das im B-Zustand befindliche Kunstharz, das sich in der Keramik befindet, wieder mehr oder weniger flüssig und auch klebrig, härtet dann aber zu einem Duroplast aus. Die zwischen--

zeitlich entstehende Klebfähigkeit ist für die Verarbeitung erfindungsgemäß imprägnierter Piezokeramik-Teile von besonderem Vorteil. Dieses nur zeitweise klebrige Kunstharz liegt über die Oberfläche der Keramikteile hinweg in extrem gleichmäßiger und dünner Schicht vor.

Ein besonderes Merkmal für das Herstellungsverfahren einer erfindungsgemäßen Keramik ist, daß das zunächst relativ poröse Keramikmaterial in Streifenform oder als Folie mit dem Kunstharz imprägniert wird und erst dann später mit den notwendigen Elektroden versehen wird. Insbesondere wird für solche Elektroden ein duktiles Material verwendet, wie z.B. Blei, Indium und ähnlich duktile Metall-Legierungen. Ein solches Elektrodenmaterial kann in Form einer Folie in Verbindung mit dem Streifen oder der Folie aus dem imprägnierten Keramikmaterial verwendet werden.

Mit der Erfindung erreicht man eine wesentlich erhöhte mechanische Festigkeit der Keramik durch zusätzliche innere Versteifung des Keramikgefüges. Die ansonsten vorhandene Brüchigkeit von dünnen Keramikteilen ist durch die Erfindung ganz wesentlich verringert.

Die Erfindung bietet darüber hinaus auch den Vorteil, daß derartig imprägnierte Keramik ganz erheblich geringere Neigung zu Spitzen- und Glimm-Entladung zeigt. Es liegt daher erhöhte elektrische Durchschlagsfestigkeit vor.

Für die Herstellung von lamellierten Piezokeramik-Körpern aus erfindungsgemäß imprägnierten Keramikstreifen bzw. -folien ergibt sich eine wesentliche Verringerung der Produktionszeiten dadurch, daß die<sup>so</sup> miteinander zu verbindenden Keramikteile und Elektrodenfolien keinen zusätzlichen Klebstoff-Auftrag benötigen. Unter Verwendung piezoelektrischer Keramik nach der Erfindung sind sogenannte piezoelektrische Tongeber und Piezokeramik-Telefonmembranen herzustellen. Es wird dazu eine an sich bekannte Blechmembran verwendet, die vorzugsweise eine aufgerauhte Oberfläche hat. Die Blechmembran, eine duktile Elektrode, die im B-Zustand befindliche imprägnierte Keramikfolie und eine weitere duktile Folie als Gegenelektrode werden in der angegebenen Reihenfolge aufeinandergeschichtet und anschließend unter Hitze-Einwirkung zusammengepreßt. Dabei härtet die Imprägnierung der Keramik aus und verklebt dieselbe auf ihren beiden Seiten mit den Elektrodenfolien. Die Blechmembran und die an ihr anliegende duktile Elektrodenfolie verbinden sich unter der Druckeinwirkung, und zwar besonders gut bei einer wie angegebenen aufgerauhten Oberfläche. Für den Fall, daß für die Blechmembran ein Aluminium verwendet wird, das bereits eine gute Duktilität hat, kann die duktile Elektrode zwischen dieser Blechmembran und der Keramikfolie auch entfallen und die Metallmembran übernimmt direkt die Funktion der auf der Keramik aufliegenden Elektrode.

Ein weiteres Anwendungsgebiet piezoelektrischer Dünnschicht-Streifen sind Piezo-Elongatoren und Transducer-Arrays. Die erfindungsgemäß imprägnierten Keramikfolien werden unter Zwischenlage der duktilen Metallelektroden entweder direkt aufeinander oder mit nichtaktiven, neutralen Zwischenstreifen aus anderem Material aufeinandergelegt. Die einzelnen Streifen können während des Aufeinanderschichtens zwecks Justierung leicht gegeneinander verschoben werden. Unter Hitze- und Druckanwendung wird der ganze Stapel dann zu einem Verbund miteinander verklebt. Dabei hat sich gezeigt, daß Lufteinschlüsse im Kunstharz verbleiben und nicht in die Keramikfolie eindringen, wo sie elektrische Störungen verursachen können. Ein solcher unter Anwendung der Erfindung hergestellter Elongator hat wesentlich erhöhte mechanische Festigkeit und weit größere elektrische Durchschlagsfestigkeit.

Hergestellt wird eine wie erfindungsgemäß imprägnierte Keramik zum Beispiel dadurch, daß die noch nicht mit Metall-Elektroden versehenen Streifen, Folien oder dergleichen aus Keramikmaterial in das im Handel erhältliche flüssige Kunstharz getaucht werden, diese Teile mit der Kunstharz-Flüssigkeit besprüht werden oder dergleichen. Im Einzelfall kann es empfehlenswert sein, das flüssige Kunstharz auf geringere Viskosität zu verdünnen und das Verdünnungsmittel dann abzudampfen. Es hat sich gezeigt, daß es für bereits wesentlich erhöhte Festigkeit schon weitgehend ausreichend ist, wenn oberflächennahe Schichtanteile der Streifen oder Folien in der Weise durchtränkt sind. Für noch weiter erhöhte elektrische Durchschlagsfestigkeit empfiehlt es sich aber, durch die gesamte Dicke des Keramikmaterials hindurchgehende Imprägnierung zu erreichen.

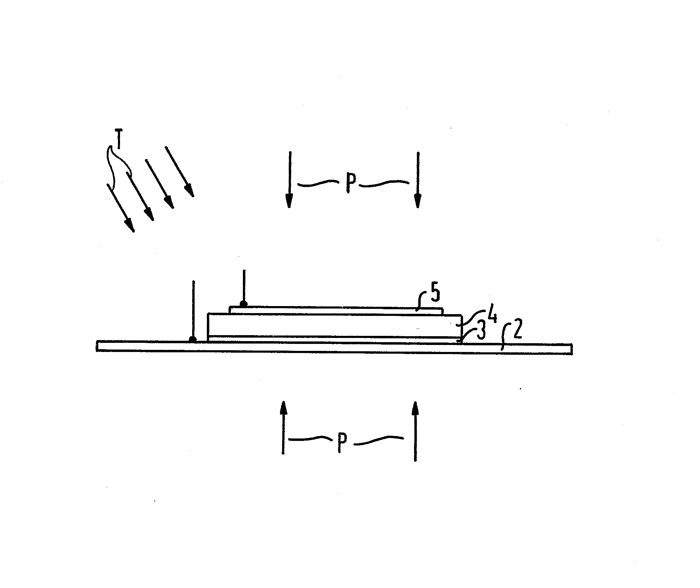

Die Figur zeigt im Schnitt einen piezoelektrischen Tongeber, der aus einer Metallmembran 2, einer Bleifolie als Elektrode 3, einem wie erfindungsgemäß imprägnierten Keramikplättchen 4 und einer weiteren duktilen Metallfolie 5 als Gegenelektrode besteht. Vor dem Zu-

0123864

83 P 1192 E

sammenpressen dieser Teile befindet sich das imprägnierende Kunstharz des Keramikplättchens 4 im B-Zustand. Bei dem unter Wärmeeinwirkung $T$ erfolgenden Zusammenpressen $P$ der Teile erfolgt sowohl die Verklebung der Teile 3, 4, 5 miteinander, die Verbindung der Teile 2 und 3 miteinander als auch das Übergehen des B-Zustandes in den endgültig ausgehärteten Zustand.

Zur oben erwähnten Duktilität der Elektroden ist anzumerken, daß diese Duktilität dazu dient, daß sich das Elektrodenmaterial durch die vorgesehene Druckeinwirkung $P$ noch etwas in die Unebenheiten und Poren des Keramikmaterials eindrückt bzw. eindringt.

Die Erfindung läßt sich auch vorteilhaft dort anwenden, wo der Piezokeramikkörper in ein dicht anschließendes Gehäuse bzw. in eine Umhüllung eingebaut wird. Die durch das verwendete Kunstharz erreichte oben erwähnte Verbindung des Keramikkörpers mit den Elektroden kann auch auf die Verbindung mit dem Gehäuse ausgedehnt werden, und zwar wiederum ohne zusätzlichen Klebstoff-Auftrag. Auch dies trägt zu einer rationellen Fertigung des gewünsch-ten Produkts bei.

0123864
83 P 1 192 E

Patentansprüche:

1. Mit Elektroden zu versehender Piezokeramikkörper, insbesondere in der Form dünner Streifen oder Folien, mit Kunststoff-Imprägnierung, g e k e n n z e i c h n e t dadurch, daß der Kunststoff ein solches Kunstharz ist, das einen stabilen B-Zustand hat und daß die Imprägnierung vor Anbringen der Elektroden (3,5) durchgeführt ist und sich in diesem B-Zustand befindet.

2. Mit Elektroden versehener Piezokeramikkörper, insbesondere in der Form dünner Streifen oder Folien, mit Kunststoff-Imprägnierung, g e k e n n z e i c h n e t dadurch, daß der Kunststoff ein solches Kunstharz ist, das einen stabilen B-Zustand hat und daß die Imprägnierung vor Anbringen der Elektroden (3,5) ausgeführt ist und die Elektroden mit dem Piezokeramikkörper (4) mittels des erst dann ausgehärteten Kunstharzes verbunden sind.

3. Piezokeramikkörper nach Anspruch 1 oder 2, g e - k e n n z e i c h n e t dadurch, daß für die Elektroden duktiles Metall verwendet ist.

4. Piezokeramikkörper nach Anspruch 1, 2 oder 3, g e - k e n n z e i c h n e t dadurch, daß eine jeweilige Elektrode als Folie auf dem Piezokeramikkörper vorliegt.